# EUROPÄISCHE PATENTANMELDUNG

(11) **EP 2 535 928 A2**
(43) Veröffentlichungstag der Anmeldung: **19.12.2012**
(21) Anmeldenummer: 12184416.1
(22) Anmeldetag: 17.04.2008
(51) Int. Cl.: H01L 23/473

(54) **Kühldose für Bauelemente oder Schaltungen**

(30) Priorität: 26.04.2007 DE 102007020170
(62) Teilanmeldung aus: 08736309.9
(71) Anmelder: CeramTec GmbH, 73207 Plochingen (DE)
(72) Erfinder: Kluge, Dr. Claus Peter, 95195 Röslau (DE)
(74) Vertreter: Uppena, Franz

(57) **Zusammenfassung**

Die Erfindung betrifft eine Kühldose (1) für elektrische oder elektronische Bauelemente oder Schaltungen aus einem Werkstoff, wobei die Kühldose (1) elektrisch nicht oder nahezu nicht leitend ist, einstückig oder mehrstückig aufgebaut ist und über ein durch den Werkstoff umhüllten Hohlraum (4) verfügt und dieser Hohlraum (4) geschlossen oder mit mindestens einer Öffnung (2) versehen ist.

Zur Verbesserung der Wärmeabfuhr wird vorgeschlagen, dass zumindest ein Oberflächenbereich der Kühldose (1) durch die Funktionen elektrische und/oder thermische Leitfähigkeit definiert ist und der Oberflächenbereich der Kühldose (1), der durch die Funktionen elektrische und/oder thermische Leitfähigkeit definiert ist, eine mit dem Werkstoff der Kühldose (1) versinterte Metallisierungsschicht (3) ist.

## Beschreibung

Die Erfindung betrifft eine Kühldose für elektrische oder elektronische Bauelemente oder Schaltungen aus einem Werkstoff, wobei die Kühldose elektrisch nicht oder nahezu nicht leitend ist, einstückig oder mehrstückig aufgebaut ist und über ein durch den Werkstoff umhüllten Hohlraum verfügt und dieser Hohlraum geschlossen oder mit mindestens einer Öffnung versehen ist.

Nach dem Stand der Technik werden zur Wärmeableitung von Modulen der Leistungselektronik planare Strukturen aufgebaut, welche die aus einer Wärmequelle (aktive oder passive elektrische Komponente) diffundierende Hitze über zahlreiche Zwischenschichten (Lote, Leitpasten, Klebstoffe, Metallisierungen) in einen elektrisch nicht leitenden, gleichmäßig geformten, einfachen geometrischen Körper (Scheibe, rechteckiges Substrat) abführen. Die Geometrie der einzelnen Komponenten ist zwar einfach, der gesamte Schichtaufbau ist kompliziert und bedingt eine konsekutive Anwendung verschiedenster fehlerbehafteter Verfahren wie Kleben, Pressen, Schrauben und eingeschränkt auch das Löten. Jede Grenzschicht dieses Stapelaufbaus stellt eine Barriere für den Wärmeübergang dar und verringert entweder die Zuverlässigkeit und/oder Lebensdauer des Moduls (Oxidation, Durchbrennen, Alterung) oder begrenzt dessen Leistung.

Kühldosen sind beschrieben in DE 296 12 943 U1, DE 91 10 268 U1, DE 92 01 158 U1, DE 195 27 674 C2 oder DE 295 14 012 U1.

Organische und keramische Schaltungsträger mit geringer oder nicht ausreichender Wärmeleitfähigkeit müssen durch zusätzliche Maßnahmen, wie elektrisch isolierende Zwischenschichten, an einen metallischen Kühlkörper dauerhaft formschlüssig angebaut werden. Bei steigenden Wärmebelastungen müssen teilweise die Wärmequellen von der Platine ausgelagert werden und im klassischen Sinne auf einen metallischen Kühlkörper montiert und mit dem Schaltungsträger elektrisch verbunden werden.

Der Aufbau aus mehreren unterschiedlichen Materialien ist komplex und ein Kompromiss, wenn man die Langzeitzuverlässigkeit betrachtet. Eine Steigerung der Leistungsdichte ist nur im geringen Umfang möglich.

Die Wärmeleitfähigkeit kann nur bedingt benutzt werden, da es sich um einen planparallelen Aufbau handelt.

Ein direkter Verbund von elektrisch leitfähigem Kühlkörper und einer Wärmequelle ist ebenso nicht möglich.

Üblicherweise wird bei Powerthyristoren ein alternierender Aufbau von Kühlkörper und Thyristor gewählt. Damit der Wärmeübergang optimal ist, wird dieser Aufbau mechanisch verspannt. Mit dieser Verspannung einher geht ein dynamischer Prozess der thermischen Expansion. Die Kontrolle der Verspannungskräfte über die Zeit ist nur durch zusätzlichen Aufwand zu gewährleisten.

Der Erfindung liegt die Aufgabe zugrunde, eine Kühldose nach dem Oberbegriff des Anspruchs 1 bezüglich der Wärmeabfuhr wesentlich zu verbessern. Weiterhin soll die Verwendungsform einer Kühldose ausgedehnt werden. In einer weiteren Aufgabe soll die Zuverlässigkeit der Kühldose und deren Thermowechselbeständigkeit verbessert werden.

Erfindungsgemäß wird diese Aufgabe durch die Merkmale des Anspruchs 1 gelöst.

Erfindungsgemäß ist zumindest ein Oberflächenbereich der Kühldose durch die Funktionen elektrische und/oder thermische Leitfähigkeit definiert. In bevorzugter Weiterbildung ist der Oberflächenbereich der Kühldose, der durch die Funktionen elektrische und/oder thermische Leitfähigkeit definiert ist, eine mit dem Werkstoff der Kühldose versinterte Metallisierungsschicht.

Durch diese eingesinterte Metallisierungsschicht ist die Wärmeabfuhr der mit der Metallisierungsschicht verbundenen (verlöteten) Komponenten wesentlich verbessert.

Im Falle von kleinflächigen Leistungshalbleitern, als Komponenten mit extremer Abwärme, kann der Verbund von Kühldose und Halbleiter bei angepassten Ausdehnungskoeffizienten ein deutlich höheres Niveau in der Zuverlässigkeit bieten.

In einer erfindungsgemäßen Ausgestaltung ist der Oberflächenbereich eine Platine. Mit Oberflächenbereich ist derjenige Teil der Kühldose gemeint, der durch die Funktionen elektrische und/oder thermische Leitfähigkeit definiert ist, d.h. derjenige Teil, der die mit dem Werkstoff der Kühldose versinterte Metallisierungsschicht aufweist. Somit hat die Kühldose gleichzeitig die Funktion einer Platine mit einer extrem hohen thermischen Leitfähigkeit.

Auf der Kühldose sind durch die Metallisierungsschicht die Leiterbahnen aufgebracht, d.h. die versinterten Metallisierungsschichten können so aufgebracht werde, dass sie eine Platine bilden. Die Leiterbahnen der Platine sind so über einen thermischen Prozess (Versinterung) mit der Kühldose innig verbunden. Zusätzlich können auch metallische Leiterbahnen aufgeklebt sein und es können Leitkleber Anwendung finden. Es können auch Kombinationen unterschiedlicher Leiterbahntypen zum Einsatz kommen.

Erfindungsgemäß haben die Komponenten einen direkten Wärmeabfluss in die Kühldose. Die Komponenten können beispielsweise direkt oder über eine oder mehrere Schichten mit der Kühldose verbunden sein.

Die Begriffe Bauelemente und Komponenten beschreiben nachfolgend dieselben Gegenstände.

In einer Ausführungsform ist der Hohlraum der Kühldose von einem Heiz- oder Kühlmedium beaufschlagt. Das Heiz- oder Kühlmedium kann dauerhaft in dem Hohlraum verbleiben oder über mindestens einen Zugang zum Hohlraum stetig oder nach Bedarf gegen ein gleiches oder unterschiedliches Heiz- oder Kühlmedium mit gleicher oder unterschiedlicher Temperatur ausgetauscht werden.

Das Heiz- oder Kühlmedium ist bevorzugt ein Gas, wie z. B. Luft oder Stickstoff oder eine Flüssigkeit, wie z. B. Wasser oder Öl.

In bevorzugter Ausgestaltung besteht die Kühldose aus mindestens einer keramischen Komponente oder einem Verbund von unterschiedlichen Keramiken. Die keramischen Komponenten können im kristallographischen Sinne einkristallin oder polykristallin oder in Kombinationen hiervon vorkommen.

Bevorzugt sind Teilstücke einer mehrstückigen Kühldose durch Verkleben, Versintern, Löten, Reaktionslöten, Verklemmen, Nieten, Verspannen und bevorzugt durch Dichten mit zusätzlichem Dichtungsmaterial miteinander verbunden. Es können auch Kombinationen von mindestens zwei unterschiedlichen Verbindungstechniken für den Zusammenbau einer aus mindestens zwei Teilstücken bestehenden zusammengebauten Kühldose bestehen.

Keramische Komponenten oder Keramiken können beispielsweise Aluminiumoxid, technisches Aluminiumoxid, Zirkonoxid, unterschiedlich dotierte Zirkonoxide, Aluminiumnitrid, Siliziumnitrid, Siliziumoxid, Glaskeramik, LTCC (Low Temperature Cofired Ceramics) Keramiken, Siliziumcarbid, Bornitrid, Boroxid sein.

Von besonderer technischer Bedeutung sind technisches 96%iges Aluminiumoxid mit Wärmeleitfähigkeiten von ca. 24 W/mK, sowie technisches >99%iges Aluminiumoxid mit ca. 28 W/mK, technische oder reine Aluminiumnitride mit beispielsweise ca. 180 W/mK, mit Zirkonoxid verstärkte Aluminiumoxide mit ca. 24 W/mK, sowie Glaskeramiken mit ca. 2 W/mK.

Hohe Wärmeleitfähigkeiten sind in Anwendungen wie Powerelektronik, High Power LED, träge Hochlastsicherungen, Prozessoren, Powerwiderstände von besonderer technischer Bedeutung. Niedrige Wärmeleitfähigkeiten sind bei flinken Hochlastwiderständen von besonderer technischer Bedeutung, sowie bei Anwendungen, bei denen eine möglichst gleichmäßige Temperaturverteilung über eine Fläche (der Kühldose) gewährleistet sein muss. Hier wären beispielsweise thermoanalytische Messaufbauten zu nennen.

In spezieller Ausgestaltung besteht die Kühldose aus einem Kompositmaterial, und das Kompositmaterial enthält elektrisch nicht oder nahezu nicht leitende Matrixmaterialien mit Wärme leitenden Zuschlagsstoffen.

Als Matrixmaterialien werden bevorzugt Harze, Polymere oder Silikone verwendet.

Die Kompositmaterialien sind in bevorzugter Ausgestaltung aus Polymeren oder Silikonen, gemischt mit keramischen Komponenten, bestehende Mehrstoffsysteme, wie zum Beispiel:
a) Polymere mit Al₂O₃
b) Polymere mit AlN
c) Silikone mit Al₂O₃/AlN
d) Silikone und Polymere mit ZrO₂/Y₂O₃

Die Kühldose kann auch ein Komposit aus Metall und/oder Keramik oder ein Verbund von Keramik und Metall sein.

Die Kühldose kann auch als Hybrid gefertigt sein, indem man bei mehrstückigen Kühldosen mindestens ein Stück metallisch ausführt. Beispielsweise können Aluminium, Kupfer, Nickel, Wolfram oder auch Edelstähle verwendet werden.

Die Metallisierungsschicht auf der Kühldose ist in einer Ausführungsform mehrschichtig aufgebaut.

Sinnvollerweise sind die elektrischen oder elektronischen Bauelemente mit der Kühldose elektrisch leitend und/oder Wärme leitend verbunden. Bauelemente können beispielsweise elektrische oder elektronische oder aktive oder passive oder geometrische Körper oder beliebige Kombinationen davon sein.

In Weiterbildung der Erfindung ist mit der Kühldose mindestens eine Montagemöglichkeit verbunden.

Über die Montagemöglichkeit kann die Kühldose mit weiteren Kühldosen mit oder ohne elektrische oder elektronische Bauelemente oder Schaltungen verbunden sein. Die Befestigung kann über Verschrauben, Nieten, Klemmen, Kleben, Crimpen, Schweißen, Löten oder weitere Befestigungsmöglichkeiten erfolgen.

Die Oberfläche des Hohlraumes der Kühldose kann die Funktionen aller Oberflächen, welche nicht zum Hohlraum der Kühldose zählen, übernehmen und umgekehrt.

In Weiterbildung der Erfindung trägt oder weist die Oberfläche der Kühldose und/oder die zum Hohlraum gehörende Oberfläche der Kühldose beliebige Oberflächenstrukturierungen auf, die den Effekt der Oberflächenveränderung nach sich zieht.

Vorteilhafterweise sind eine oder mehrere Oberflächenstrukturierungen oder deren Kombinationen auf der Kühldose angeordnet, und die Oberflächenstrukturierungen sind zum Beispiel Aufrauungen, Riefen, Wellen, Durchbrüche in der Oberfläche oder dendritische oder verästelnde Strukturen.

Bevorzugt sind die Oberflächenstrukturierungen z.B. planare oder unebene oder raue Oberflächen, die mit ebenfalls unebenen oder planaren oder rauen Oberflächen von zu montierenden Komponenten insbesondere formschlüssig und/oder dauerhaft und/oder temporär oder als Kombination hiervon verbunden sind. Die Verbindungsart kann beispielsweise Löten oder Kleben sein.

In spezieller Ausführungsform hat die Kühldose vollflächigen oder teilflächigen Formschluss mit Bauelementen. Der Verbund kann beispielsweise dauerhaft oder temporär oder als Kombination hiervon vorliegen. Bauelemente können beispielsweise elektrische oder elektronische oder aktive oder passive oder geometrische Körper oder beliebige Kombinationen davon sein.

In einer Ausgestaltung ist die Kühldose flächig oder mit Aussparungen oder mit Erhöhungen versehen, wobei diese einstückig oder mehrstückig mit dem jeweiligen Kühldosenelement ausgebildet sind.

Weiterhin sind bevorzugt die Metallisierungsschichten größer 5 µm und über DCB Verfahren (Direct Copper Bonding) oder AMB Verfahren (Active Metall Brasing) aufgebracht. Die Metallisierungsschichten können beispielsweise aus Kupfer oder Aluminium oder Kombinationen hiervon bestehen.

Der erfindungsgemäße Aufbau mit Komponenten liegt beispielsweise im Ruhezustand bei Raumtemperatur vor. Während des Betriebes können nun an den Komponenten durch den Betrieb derselben in kürzester Zeit lokale Temperaturmaxima entstehen. Es kommt zu einem so genannten Thermoschock der Umgebung der Komponente. Der erfindungsgemäße Aufbau kann diesen Zustand ohne Eigenschädigung überstehen. Finden diese Zustände im Wechsel statt, ein so genannter Thermowechsel, kommt es bei herkömmlichen Aufbauten mit beispielsweise geklebten Leiterbahnen, nach relativ wenigen Zyklen beispielsweise zu Ablöseerscheinungen von Leiterbahnen der Kühldose. Der erfindungsgemäße Aufbau zeigt eine deutlich verbesserte Thermowechselbeständigkeit wie herkömmliche Aufbauten.

In Weiterbildung der Erfindung sind auf der Kühldose gleiche oder unterschiedliche Bauelemente in gleicher oder unterschiedlicher räumlicher Ausrichtung befestigt. Die Ausrichtung kann beispielsweise durch unterschiedliche Lotmengen oder Aussparungen oder Erhöhungen oder beliebige Kombinationen von Ausrichtungsmöglichkeiten erfolgen. Bei z. B. LED's kann dadurch deren Ausrichtung und damit der Lichtschein auf einfache Art und Weise ausgerichtet werden.

Die erfindungsgemäße Kühldose lässt sich vorteilhaft als Montagekörper für Bauelemente, insbesondere elektrische oder elektronische Bauelemente verwenden.

In einer Ausgestaltung der Erfindung ist die Kühldose mit sensorischen Komponenten verbunden. Sensorische Komponenten können beispielsweise Signale abgeben aus denen Größen wie Druck, Temperatur, Gewicht, etc. abgeleitet werden.

In einer Ausgestaltung der Erfindung werden aus der teilweisen oder gesamten Verformung der Kühldose sensorische Signale abgeleitet.

Erfindungsgemäß ist die Kühldose teilweise mit metallischen Bereichen versehen. Diese Bereiche können die Ober- und Unterseite der Kühldose beispielsweise elektrisch miteinander verbinden.

Bevorzugt baut die Kühldose nahezu kein elektrochemisches Potential gegenüber anderen Materialien auf. Damit kann beispielsweise bei entsprechender Koppelung die Korrosion der Kühldose oder der Umgebung signifikant vermindert werden.

In erfinderischer Ausgestaltung wird die Kühldose als Wärmequelle verwendet, in dem die entstehende Wärme über die Kühldose an das zu temperierende Medium abgegeben wird. Das zu temperierende Medium kann die Hohlraumoberfläche oder die nicht dem Hohlraum zugeordnete Fläche berühren.

Bevorzugt weist die Kühldose durch zugeführte Wärme oder Kälte, welche auf die Kühldose übertragen wird, eine gezielte Temperaturverteilung auf. Beispielsweise können somit Temperaturdifferenzen der Umgebung gezielt ausgeglichen werden.

Bevorzugt sind auf der Kühldose Stoffe aufgebracht, welche Bondprozesse ermöglichen. Beispielhaft kann hier ein Metallisierungsaufbau W-Ni-Au (Wolfram-Nickel-Gold) verwendet werden, um Golddrahtbonding zu ermöglichen. Die Stoffe können aus einem oder mehreren Materialien bestehen, die gemischt oder aus mindestens einer Schicht auf der Kühldose aufgebracht sind. Die Stoffe können beispielsweise Materialien wie Gold oder Schichten aus mehreren Materialien wie Kupfer, Nickel und Gold oder aus Mischungen von mindestens zwei unterschiedlichen Materialien, wie beispielsweise Metallen und/oder Zuschlagstoffen, sowie Schichten aus gleichen oder unterschiedlichen Metallen oder Zuschlagstoffen bestehen.

In Weiterbildung der Erfindung ist mit der Kühldose eine oder mehrere Licht emittierende Stoffe oder einer oder mehrere Licht emittierende Komponenten oder Kombinationen hiervon verbunden. Beispielsweise kann dieses ein Halbleiter oder ein Gehäuse mit einem Halbleiter sein, wie es für LED Beleuchtungen eingesetzt wird.

Bevorzugt sind mit der Kühldose Metalle oder Metallschichten innig oder durch mechanischen Formschluss vollflächig oder teilflächig verbundenen und besitzen eine gleiche oder unterschiedliche Wärmeleitfähigkeit wie die Kühldose. Metalle oder Metallschichten können beispielsweise Wolfram, Silber, Gold, Kupfer, Platin, Palladium, Nickel in reiner oder technischer Qualität sein oder Mischungen von mindestens zwei unterschiedlichen Metallen sein. Metalle oder Metallschichten können auch beispielsweise mit Haft vermittelnden oder anderen Zuschlagstoffen wie Gläsern oder polymeren Materialien vermischt sein. Metalle oder Metallschichten können beispielsweise auch Reaktionslote, Weichlote oder Hartlote sein.

Es ist besonders hervorzuheben, dass im Falle von punktförmigen Wärmequellen die Wärme sehr schnell über die gesamte Oberfläche der Kühldose gespreizt, d.h. verteilt werden muss. Somit kann die Kühldose, mit vergleichsweise geringer Wärmeleitfähigkeit, die entstehende Wärme über das Metall auf seine Gesamtfläche verteilt bekommen. Da die Kühldose elektrisch isolierend ist kann das Metall gleichzeitig die Funktion elektrische Leitfähigkeit und thermische Leitfähigkeit erfüllen.

In erfindungsgemäßer Ausgestaltung können die Metalle oder die Metallschichten auf den Kühldosen verschiedene Funktionen haben. So können sie die Funktion der elektrischen Leitfähigkeit und/oder der thermischen Leitfähigkeit oder die Funktion einer Farbveränderung der Oberfläche oder thermische Spreizung oder ein Haftvermittler zu dritten Materialien, wie beispielsweise Loten, Klebern, sowie beliebige Kombinationen der Funktionen gleicher oder verschiedener Metallbereiche haben.

Der Vorteil liegt in der angepassten Stromtragfähigkeit der Metallbereiche. Daher müssen diese zum Beispiel nicht zwingend die gleichen Höhen oder Dicken haben.

Folglich sind die Metalle bzw. die Metallisierungsschichten vollflächig oder teilflächig in gleichen oder unterschiedlichen Dicken (Höhen) mit dem Werkstoff der Kühldose in gleichen oder unterschiedlichen Metallbereichen verbunden.

In einer anderen erfindungsgemäßen Ausgestaltung sind gleiche oder unterschiedliche Metalle als Metallisierungsschichten einschichtig oder mehrschichtig mit gleichen oder unterschiedlichen Dicken (Höhen) mit dem Werkstoff der Kühldose vollflächig oder teilflächig verbunden.

In einer weiteren Ausgestaltung trägt die Kühldose die Eigenfärbung des oder der verwendeten Materialen vollflächig oder teilflächig oder Teilbereiche der Kühldose sind abweichend von der Eigenfärbung verfärbt.

Die Kühldose, auf Basis eines technischen Aluminiumoxides, kann beispielsweise während des Herstellungsprozesses desselben mit farbgebenden Zusatzstoffen versehen werden, so dass als Resultat einer thermischen Behandlung das Bulk Material vollständig und mechanisch untrennbar durchgefärbt ist.

Die Kühldose, beispielsweise auf Basis eines technischen Zirkonoxides, kann nach dem Herstellungsprozess desselben beispielsweise oberflächlich mit farbgebenden Zusatzstoffen versehen werden, so dass als Resultat einer thermischen Behandlung die Oberfläche des Bulk Materials vollständig durchgefärbt ist. Je nach Eindringtiefe der resultierenden Verfärbung kann das Bulk Material auch seine Eigenfärbung im inneren behalten. Der Gradient der Verfärbung kann unterschiedlichste Charakteristiken annehmen.

Die Kühldose, beispielsweise auf Basis eines technischen Aluminiumnitrides, kann mit farbgebenden Schichten versehen werden, so dass als Resultat das Bulk Material der Kühldose nicht verfärbt wird und die farbliche Veränderung lediglich durch eine oder mehrere mechanisch trennbaren Schichten erzeugt wird. Farbgebende Schichten können beispielsweise Lacke, Lasuren, Klebefolien, Metalle etc. sein.

In einer anderen Ausgestaltung ist die Kühldose mit mindestens einer weiteren geometrisch gleichen oder ungleichen Kühldose über geeignete Verbindungsmaterialien zu einer Art dreidimensionalem Array verbunden.

Verbindungsmaterialien können einschichtiger oder mehrschichtiger Natur sein. Verbindungsmaterialien können gleichartig oder unterschiedlich sein oder auch in Kombination mit einschichtigem oder mehrschichtigem Aufbau verwendet werden. Beispielhaft sind Verbindungsmaterialien wie Kleber, Metallisierungen, Metalle, Metalle die beispielhaft mit Verfahren wie DCB (Direct Copper Bonding oder AMB (Active Metal Brazing) mit der Kühldose verbunden worden sind, zu nennen. Es können auch beispielsweise Lote, Reaktionslote, beidseitige Klebefolien, etc. verwendet werden.

In einer Ausführungsform ist die Kühldose mit einem oder mehreren Licht emittierenden Stoffen oder einer oder mehrerer Licht emittierender Komponenten sowie Kombinationen hiervon verbunden und ist bevorzugt gleichzeitig mit genormten oder ungenormten elektrischen Verbindern versehen. Es können auch Kombinationen von gleichen oder unterschiedlichen elektrischen Verbindern eingesetzt werden. Es wird bevorzugt eine dem elektrischen Verbinder angemessene mechanische Verbindung zu der Kühldose verwendet. Elektrische Verbinder können beispielsweise Lampensockel E27, E14, GU-Serie, G-Serie, U-Serie, R-Serie, Stecksockel, Bayonettsockel, Klemmverbinder, Schraubverbinder, Steckver-binder, etc. sein. Mechanische Verbindungen oder Kombinationen von mechanischen Verbindungen können beispielsweise Kleben, Löten, Quetschen, Nieten, Klemmen, etc. sein.

In weiterer Ausgestaltung ist mindestens eine Kühldose mit mindestens einem weiteren geometrischen Körper über geeignete Verbindungsmaterialien zu einer Art dreidimensionalem Aufbau verbunden. Verbindungsmaterialien können einschichtiger oder mehrschichtiger Natur sein. Verbindungsmaterialien können gleichartig oder unterschiedlich sein oder auch in Kombination mit einschichtigem oder mehrschichtigem Aufbau verwendet werden. Mindestens eine oder mehrere gleiche oder ungleiche Kühldosen können an beliebigen Stellen in gleichen oder unterschiedlichen Orientierungen angebracht sein. Beispielhaft wären Verbindungsmaterialien, wie Kleber, Metallisierungen, Metalle, Metalle die beispielhaft mit Verfahren wie DCB (Direct Copper Bonding oder AMB (Active Metal Brazing) mit der Kühldose verbunden worden sind, Lote, Reaktionslote, beidseitige Klebefolien, etc. zu nennen. Beispielhaft können geometrische Körper Platten sein, auf denen sich in unterschiedlichen Bereichen mindestens eine oder mehrere gleiche oder unterschiedliche Kühldosen befinden.

Die Kühldose kann beispielsweise Bestandteil eines Kunststoffgehäuses sein.

In einer anderen Ausgestaltung sind mindestens eine und/oder unterschiedliche oder gleiche Kühldosen beliebig oder gleichsinnig orientiert in ein Matrixmaterial eingebettet. Das Einbetten kann beispielsweise durch Injection moulding oder Druckguss geschehen. Die Einbettmassen selber sind beliebig und den jeweiligen Zielfunktionen entsprechend auszuwählen. Kunststoffe eignen sich vorzüglich.

Erfindungsgemäß ist bei einer Kühldose durch Modifikation der Größe oder der Einfärbung oder einer Modifikation der Geometrie der metallisierten Bereiche bzw. der Metallisierungsschichten oder Kombinationen von diesen eine Veränderung des Wärmetransportes erreicht. Verändert man beispielsweise das Design des Hohlraumes in der Kühldose kann sich bei konstantem Wärmeeintrag, über die Abgabe oder Aufnahme von Wärmeenergie, die Absoluttemperatur im eingeschwungenen Zustand bzw. im Gleichgewichtszustand verändern. Dies kann beispielsweise auch durch gezieltes Hinzufügen oder Entfernen oder Vergrößern oder Verkleinern des Hohlraumes in der Kühldose stattfinden. Die Veränderung kann beispielsweise auch durch Veränderung der Farbe stattfinden. So ist die Abstrahlcharakteristik eines schwarzen Körpers anders als bei einem weißen Körper.

Die Oberfläche des Hohlraumes kann auch die Funktionen der nicht zum Hohlraum zählenden Oberfläche übernehmen, d.h. zum Beispiel als Platine ausgebildet sein. Die Metallisierungsschichten sind auf der äußeren oder inneren Oberfläche der Kühldose durch Versintern aufgebracht.

Hochleistungshalbleiter mit oder ohne thermische Verlustleistung, wie beispielsweise MOS-FET, IGBT, Prozessorkerne, sind bevorzugt direkt oder indirekt mit der Kühldose verbunden. Hierdurch wird gleichzeitig und von selbst die entstehende Abwärme an den Werkstoff der Kühldose weitergeben. Der Werkstoff der Kühldose kann die Wärmemenge dann an das Heiz- oder Kühlmedium weitergeben. Der Vorgang kann auch in umgekehrter Richtung verlaufen, so dass Wärmemenge aus dem Heiz- oder Kühlmedium entnommen wird. Es kann auch eine Kombination beider Transportrichtungen genutzt werden.

In erfindungsgemäßer Ausgestaltung bestehen die Metallisierungsbereiche aus Wolfram und sind chemisch vernickelt und/oder vergoldet. Die Metallisierungsbereiche sind in einer Ausgestaltung kreisförmig ausgebildet.

In spezieller Ausgestaltung ist die Kühldose mit elektrischen Leiterbahnen versehen, über die elektrische Spannungen bis in den kV Bereich hinein transportierbar sind, ohne dass ein elektrischer Spannungsabfluss über den Werkstoff der Kühldose erfolgt. Von besonderem technischen Interesse sind elektrische Spannungsbereiche von 1 Volt bis 600 Volt, sowie Spannungen >> 2 k-Volt (2.000 Volt).

In bevorzugter Ausführungsform weist die Kühldose keine oder eine geringe Abschirmwirkung gegenüber elektrischen oder magnetischen oder elektromagnetischen Feldern oder Kombinationen von diesen auf, wodurch diese Felder die Kühldose durchdringen können.

In einer Ausgestaltung ist die Kühldose gezielt vollflächig oder teilflächig mit Materialien versehen, deren Funktion es ist Bereiche zu schaffen, in denen eine unterschiedliche Abschirmwirkung gegenüber elektrischen oder magnetischen oder elektromagnetischen Feldern oder Kombinationen hiervon, im Vergleich zu der Abschirmwirkung des Werkstoffs der Kühldose auftritt.

Bevorzugt sind durch gezieltes Aufbringen von geeigneten Materialien, wie beispielsweise Metallen, auf der Kühldose Bereiche angeordnet, die aufgrund ihrer Geometrie über induktive oder kapazitive Effekte oder Kombinationen von diesen in der Lage sind elektrische oder magnetische oder elektromagnetische Signale zu empfangen oder zu senden. Signale im weitesten Sinne dienen der drahtlosen Übertragung von Energie. Die Energie kann beispielsweise durch Modulation zusätzliche Informationen mit übertragen.

In einer erfindungsgemäßen Ausgestaltung ist die Kühldose mit der Funktionalität einer intelligenten Selbstidentifizierung ausgestattet. Selbstidentifizierung kann beispielsweise ein Schriftzug oder eine Markierung oder ein Magnetstreifen mit entsprechender Information oder eine RFID Einheit (Radiofrequenz-Identifikation) oder Kombinationen dieser sein.

In einer Ausgestaltung ist die Kühldose direkt oder indirekt mit mindestens einer Laserdiode gleicher oder unterschiedlicher Wellenlänge verbunden. Laserdiode kann ein Modul sein oder der lichtemittierende Halbleiter selber. Eine indirekte Verbindung wäre beispielsweise Aufschrauben, Verkleben, Verklemmen. Eine direkte Verbindung wäre beispielsweise das Auflöten.

In einer Ausführungsform ist die Kühldose mit mindestens einem Powermodul gleicher oder unterschiedlicher Bauweise, welches beispielsweise den Anlaufstrom eines Elektromotors regelt, direkt oder indirekt verbunden. Eine indirekte Verbindung wäre beispielsweise Aufschrauben, Verkleben, Verklemmen. Eine direkte Verbindung wäre beispielsweise das Auflöten.

In einer Ausführungsform ist auf einer Kühldose nur ein elektrischer Leiter eines Leistungshalbleiters beispielsweise gelötet und ist zumindest ein anderer elektrischer Leiter des Leistungshalbleiters auf einer anderen Kühldose beispielsweise gelötet um einen optimalen Wärmeübergang bei gleichzeitiger elektrischer Isolation zu gewährleisten. Geeignete Leistungshalbleiter können so beispielsweise mit mindestens zwei Kühldosen verlötet werden, um den gewünschten Kühleffekt über eine Art Sandwich Aufbau zu verstärken.

In einer Ausführungsform ist der Werkstoff der Kühldose so gewählt, dass die Kühldose mit korrosiven oder ionisch leitfähigen Heiz- oder Kühlmedien in Berührung kommen kann.

In einer Ausführungsform ist die Kühldose mit genormten oder ungenormten Verbindern für das Heiz- oder Kühlmedium ausgestattet.

Bevorzugt enthält das Mateial der Kühldose bzw. der Keramikwerkstoff als Hauptkomponente 50,1 Gew-% bis 100 Gew-% ZrO2/HfO2 oder 50,1 Gew-% bis 100 Gew-% Al2O3 oder 50,1 Gew-% bis 100 Gew-% AlN oder 50,1 Gew-% bis 100 Gew-% Si3N4 oder 50,1 Gew-% bis 100 Gew-% BeO, 50,1 Gew-% bis 100 Gew-% SiC oder eine Kombinatinon von mindestens zwei der Hauptkomponenten in beliebiger Kombination im angegebenen Anteilsbereich sowie als Nebenkomponente die Elemente Ca, Sr, Si, Mg, B,Y, Sc, Ce, Cu, Zn, Pb in mindestens einer Oxidationsstufe und/oder Verbindung mit einem Anteil von ≤ 49,9 Gew-% einzeln oder in beliebiger Kombination im angegebenen Anteilsbereich und sind die Hauptkomponenten und die Nebenkomponenten, unter Abzug eines Anteils an Verunreinigungen von ≤ 3 Gew-%, in beliebiger Kombination miteinander zu einer Gesamtzusammensetzung von 100 Gew-% miteinander kombiniert.

In einer Ausführungsform besteht bei mehrstückigen Kühldosen mindestens ein Stück der Kühldose aus einem metallischen Werkstoff. Als metallische Werkstoffe sind beispielsweise Aluminium, Kupfer, Nickel, sowie die technischen Varianten der Reinstmetalle oder Edelstähle zu nennen.

In einer Ausführungsform besteht das metallische Stück einer Kühldose aus Kombinationen unterschiedlicher Metalle.

In einer Ausführungsform sind vollflächige oder teilflächige Bereiche der Kühldose mit hochstromtragfähigen Leiterbahnen und hochstromtragfähigen genormten oder ungenormten Leiteranschlüssen versehen.

In einer Ausführungsform ist auf die Kühldose mindestens eine dünne Schicht < 1.000 µm gleichen oder unterschiedlichen Materials durch Sputter- oder Lithografieverfahren oder Kombinationen derselben vollflächig oder teilflächig aufgebracht.

In einer Ausführungsform findet ein alternierender Stapelaufbau von Kühldose und zu kühlendem Bauteil durch teilweises oder vollständiges Verbinden einzelner oder aller Ebenen des Stapels statt. Verbinden kann beispielsweise Kleben oder Klemmen oder Löten oder Hartlöten oder phase change Materialien sein.

Bevorzugt sind mehrstückige Kühldosen mit den Verfahren DCB (direct copper bonding) oder AMB (active metal brazing) oder Metallilisierungen wie Wolfram miteinander verbunden. Dabei können die Metalle die Dichtfläche vollflächig oder teilflächig abdecken und/oder größer wie die eigentliche Dichtfläche sein.

In einer Ausführungsform übernehmen Metallbereiche, die größer als die Dichtfläche sind, auch andere Funktionen, wie die einer Dichtung. Andere Funktionen können beispielsweise eine Montagemöglichkeit, elektrische Signalweiterleitung, elektrischer Anschluss, thermische Leitung, Verbindung zu einer weiteren Kühldose oder Kombinationen hiervon sein.

In einer Ausführungsform sind die Heiz- oder Kühlmedienanschlüsse von mindestens zwei Kühldosen miteinander in Reihe oder Parallel verschaltet.

In einer Ausführungsform wird mindestens einer Kühldose Wärmemenge zugeführt und mindestens einer weiteren Kühldose Wärmemenge entzogen. Dieser Zustand der Wärmeflussrichtung kann, bezogen auf die einzelne Kühldose, statisch oder umkehrbar oder dynamisch wechselnd sein. Der Heiz- oder Kühlmedienkreislauf kann geschlossen oder offen oder mit einem Druckausgleich versehen sein.

In einer Ausführungsform besitzt die Kühldose mindestens zwei separate in sich geschlossene Hohlräume. Die Hohlräume können geschlossen oder jeweils mit mindestens einem Zugang versehen sein. In den Hohlräumen können sich gleiche oder unterschiedliche Heiz- oder Kühlmittel in gleichen oder unterschiedlichen Zuständen befinden.

In einer Ausführungsform sind mindestens zwei Hohlräume innerhalb der Kühldose oder außerhalb über die Heiz- oder Kühlmittelzugänge oder Kombinationen hiervon miteinander in Reihe oder Parallel, oder Kombinationen hiervon, verschaltet.

In einer Ausführungsform durchströmt das Heiz- oder Kühlmedium die Kühldose über Konvektion oder wird durch eine Pumpe umgewälzt oder durch Kombination derselben.

In einer Ausführungsform ist die Kühldose mit genormten oder ungenormten optischen oder optoelektrischen Verbindern oder Komponenten versehen. Verbinder oder Komponenten können beispielsweise Ferrulen oder optoelektrische Wandler oder Lichtleiteranschlüsse sein.

In einer Ausführungsform ist mit der Kühldose eine RFID Einheit verbunden.

In einer Ausführungsform ist mindestens eine Leiterbahn der RFID Einheit und/oder mindestens eine Antenne der RFID Einheit und/oder mindestens ein aktives und/oder passives Bauteil der RFID Einheit mit der Kühldose verbunden.

In einem Ausführungsbeispiel besteht die Kühldose aus technischem Aluminiumoxid mit einem minimalen Aluminiumoxidgehalt von 89%. Die Metallisierungsbereiche sind dazu geeignet, beispielsweise Bauteile auflöten zu können und damit einen innigen Verbund herzustellen. Der Verbund mit beispielsweise einer handelsüblichen LED kann über eine Lotverbindung hergestellt werden. Die Lotverbindung hat mindestens die Funktionen der mechanischen Verbindung von LED und Kühldose. Zusätzlich ermöglichen die Metallisierungsbereiche die elektrische Kontaktierung der LED sowie den thermischen Kontakt.

Am Beispiel eine Aufbaues einer Kühldose mit aufgedruckten und versinterten Metallisierungsbereichen (auch Leiterbahnquerschnitten) mit aufgelöteter Punktwärmequelle, beispielsweise einer LED, kann der technisch notwendige elektrische Leiterbahnquerschnitt signifikant größer gewählt werden als erforderlich, da gleichzeitig zur elektrischen Leitung über die Metallisierungsbereiche und Leiterbahnquerschnitte auch die Wärmespreizung auf eine größere Oberfläche der Kühldose stattfindet. Gegenüber einem elektrisch sinnvollen und ausreichenden kleineren Metallisierungsbereich und Leiterbahnquerschnitt kann über vergrößerte Metallisierungsbereiche und Leiterbahnquerschnitte eine größere Wärmemenge in kürzerer Zeit über die Fläche der Kühldose verteilt werden.

Die Kühldose, nachfolgend auch Körper genannt, kann bevorzugt aus mindestens einer keramischen Komponente oder einem Verbund von unterschiedlichen Keramiken bestehen. Beispielsweise sind technisches Aluminiumoxid 80 - 99,9 %, Aluminiumoxid, Berylliumoxid, Zirkonoxid, stabilisiertes Zirkonoxid, Aluminiumnitrid, zirkonverstärktes Aluminiumoxid, Glaskeramik oder Keramiken die durch Mischungen von mindestens zwei verschiedenen Keramiken oder Zusätzen entstanden sind, zu benennen. Einkristalline Keramiken können beispielsweise Saphir sein.

Der Körper kann auch aus einem Kompositmaterial bestehen. Es können Matrixmaterialien, z. B. Harze, Polymere oder Silikone mit Zuschlagstoffen verwendet werden. Die Zuschlagstoffe bewirken eine Veränderung der Wärmeleitfähigkeit der Matrixmaterialien. Mehrstoffsysteme können bevorzugt sein Polymere mit Al₂O₃, Polymere mit AlN, Silikone mit Al₂O₃/AlN.

Der Körper kann starr oder flexibel oder eine Kombination von starr-flexibel sein.

Der Körper kann ein Komposit Metall - Keramik oder ein Verbund von Körper und Metall sein.

Der Körper kann mehrschichtig aufgebaut sein mit innen liegenden Leiterbahnen und elektrischen Bauteilen wie Widerstände, Spulen, Kondensatoren, etc., wobei auch elektrisch leitfähige Bereiche zwischen den Lagen möglich sind.

Der Körper kann auch als Ersatz für einen elektrisch leitfähigen Kühlkörper eingesetzt werden, hier insbesondere, wenn die Umgebung korrosiv wirkt.

Der Körper kann gleichzeitig auch Montagegehäuse sein.

Die Verwendung der erfindungsgemäßen Kühldose hat folgende Vorteile:
➢ Reduzierung der Komponentenvielfalt
➢ Erweitern der Funktionsvielfalt
➢ Eigensicherung gegen thermische Überlast
➢ Langzeitzuverlässigkeit
➢ Vermeidung TCE missmatch durch Verwendung unterschiedlichster Materialien
➢ Leistungssteigerung durch verbesserte Wärmeabfuhr
➢ Schwierigkeit, hohe Verlustwärmen direkt abzuführen, wurde überwunden
➢ Grundprinzip lässt sich auf mannigfaltige Anwendungen übertragen
➢ Eine "von selbst" systemimmanente thermische Balance
➢ Umweg Wärmequelle in einem separaten Gehäuse zu montieren, welches wiederum auf Körper montiert werden kann, ist eliminiert

Wärmequellen können elektrische oder elektronische Bauteile sein, wie z. B. Heizelemente, Peltierelemente, Widerstände, aktive und passive Halbleiter.

Die Wärme kann bewusst als Funktion erzeugt werden oder als Nebenprodukt bei der Ausübung der Funktion anfallen.

Die Wärmequellen können auch während des Betriebes Änderungen in der Funktionsfähigkeit durch die eigene produzierte Wärme erfahren.

Die Wärmequellen können direkt mit dem Körper, z. B. mit einer Lötverbindung, verbunden werden.

### IGBT

Module werden je Fläche mit immer höheren Leistungen belegt und die dauerhafte Funktionsfähigkeit dieser Module kann nur durch Montage von Kühlkörpern gewährleistet werden.

Hier wird die erfindungsgemäße Kühldose zur thermischen Ableitung gewählt.

### LED (Light emitting diode) oder Laserdioden

Mit dem Stand der Technik ist es bisher nicht oder nur eingeschränkt möglich, höhere geforderte Leuchtdichten zu erreichen. Gründe sind das mit dem nach Stand der Technik verbundene schlechte thermische Management. Mit steigender Leuchtdichte steigt die Abwärme. Die Abwärme beeinflusst die Lebensdauer und die Farbkonstanz signifikant. Gleiches gilt auch für Anwendungen mit Laserdioden.

Erfindungsgemäß können die Halbleiter direkt auf eine Platine montiert werden oder zuvor eingehaust und dann als Bauteil auf die Platine gesetzt werden. Die auf der Platine angeordnete Schaltung wiederum wird erfindungsgemäß durch die Kühldose gekühlt oder der Halbleiter wird direkt mit einer zusätzlichen Kühldose versehen. Halbleiter können beispielsweise auch Solarzellen sein, da deren Leistungsabgabe mit steigender Temperatur sinkt. In diesem Fall würde der Halbleiter selber durch den Betrieb keine Abwärme produzieren die abgeführt werden muss, sondern hier wird der Halbleiter durch den IR-Anteil des Sonnenlichtes aufgewärmt.

### Steuerungen

Nach dem Stand der Technik werden z. B. im Automobil die Wärmequellen von der Schaltung separiert und elektrisch verbunden. Auch hier kommt der Aufbau mit Wärme leitfähigen Kühlkörpern zum Einsatz.

### Korrosion von Kühlkörpern

Unter bestimmten Anwendungsbedingungen kommt es bei elektrisch leitenden Kühlkörpern zur Oberflächenkorrosion. Die durch chemische Umwandlung entstehenden Oberflächenverbindungen verändern den Übergang zum Kühlmedium und können auch die Oberfläche, z. B. durch Lochfraß, verändern. Kühldosen aus einer Keramik beheben dieses Problem.

### Keramisches Heizelement

Verwendung zur thermischen Stabilisierung des Kühlkörpers selber, bzw. der direkten oder indirekten Umgebung.

### Peltieranwendung

Peltierelemente haben eine kalte und warme Seite. Je nach Anwendung ist der Aufbau immer in Kombination mit einem separaten Kühlkörper zu sehen. Hier kann das Peltierelement direkt auf den elektrisch isolierenden Kühlkörper aufgebracht werden. Auch kann der umgekehrte Effekt genutzt werden um aus einer Temperaturdifferenz elektrische Spannung zu generieren (Seebeck Effekt).

### Sensorik intern / oberflächlich wegen direkter Rückkopplung im eigenen System

Der Kühlkörper selber kann eingebrachte oder auf eine Oberfläche montierte/aufgebrachte Sensorik enthalten. Durch die direkte Ankopplung an das System sind selbst regulierende Schutzfunktionen der Wärmequellen möglich.

### Montage des Kühlkörpers

Montagepunkte, Pads, Kavitäten, Montagebolzen
Aktive und passive Kühlung
- Bohrungen
- Lüfter
- Rippen in Kühlmedium anders als Luft

Der Stand der Technik erfordert bei der Montage von Bauteil und Kühlkörper oft auch eine Dritte Komponente, eine so genannte Wärmeleitfolie, welche gleichzeitig auch elektrisch isolierend sein muss. Damit der gewünschte Effekt der Wärmeabfuhr erzielt werden kann, müssen Kühlkörper und Bauteil ebene und planparallele Oberflächen ausweisen, damit ein 100%iger Formschluss gewährleistet ist. Kommt noch eine Wärmeleitfolie hinzu, muss auch diese eine ebene und planparallele Oberfläche ausweisen. Bei der Montage eines solchen Aufbaues wird oft eine Verschraubung gewählt. Kommt es nun bei der Montage oder während des Betriebes zu Verzügen im Aufbau, kann der thermische Kontakt partiell verloren gehen. Damit ist die Funktionalität und Lebensdauer des Aufbaues in Frage gestellt.

Erfindungsgemäß steht nun erstmalig die Möglichkeit einer Lötverbindung auf den elektrisch isolierenden Kühlkörpern, wobei die oben beschriebenen Nachteile der thermischen Ankoppelung während des Lötvorganges nicht entstehen.

### Mehrlagen Sandwichaufbau

Einfache mechanische Verbindungen des Kühlkörpers zur Montage der Einheit selber und zur Verbindung mit weiteren Kühlkörpern und/oder an Körper gebundene Funktionen.

### Selbstgekühlte Platine

Stand der Technik ist es, eine Platine mit unzureichendem thermischen Management mit einem elektrisch leitfähigen Kühlkörper zu versehen. Dabei sind der thermischen Anbindung insofern Grenzen gesetzt, als diese langzeitstabil sein muss. Limitierende Faktoren sind z. B. die zeitliche und geometrische Veränderung des elektrisch isolierenden Mediums.

### Nachfolgend wird die Erfindung anhand von Figuren erläutert.

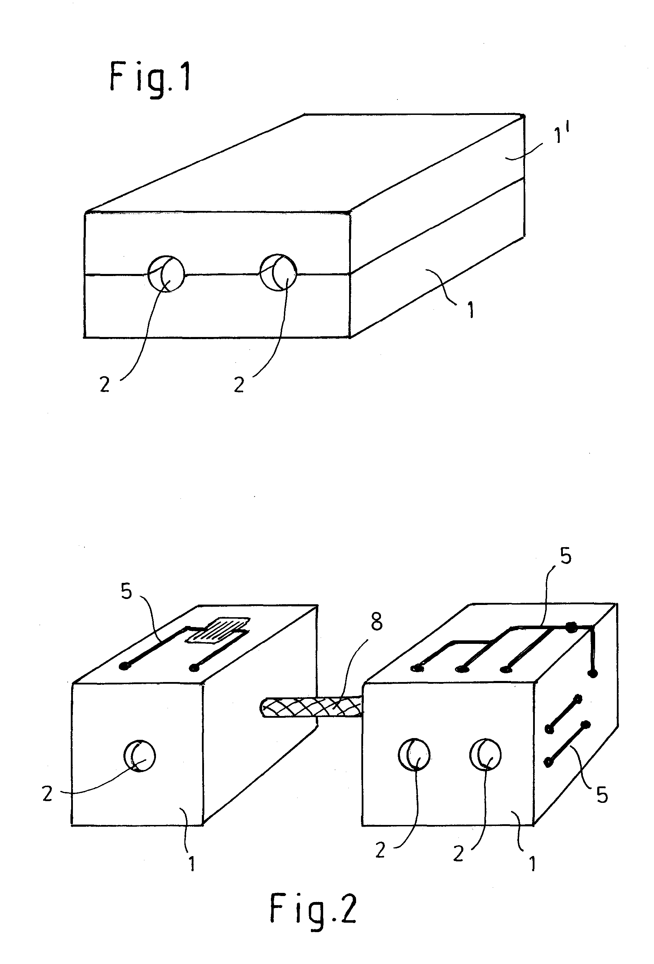

Figur 1 zeigt eine Kühldose 1, die aus zwei Teilstücken 1' besteht. Die beiden Teilstücke 1' sind in der hier gezeigten Ausbildung identisch und umschließen einen Hohlraum, der zwischen den beiden Teilstücken 1' angeordnet ist. Der Hohlraum ist in dieser Figur nicht sichtbar. Dieser Hohlraum steht über zwei Öffnungen 2 mit der Außenwelt in Verbindung. Über die beiden Öffnungen kann ein Kühlmedium in den Hohlraum geleitet werden.
Figur 2 zeigt zwei erfindungsgemäße Kühldosen 1, die beide jeweils einen Hohlraum, in der Figur nicht sichtbar, einschließen. Beide Kühldosen 1 sind einstückig ausgebildet und sind über eine Montagemöglichkeit 8, hier ein an den Kühldosen 1 angelöteter Bolzen miteinander verbunden. Die Hohlräume stehen über Öffnungen 2 mit der Außenwelt in Verbindung. Eine Kühldose weist nur eine einzige Öffnung 2 auf. Das Kühlmedium kann in diesem Fall durch Konvektion in den Hohlraum gelangen. Die andere gezeigte Kühldose weist zwei Öffnungen 2 auf. Das Kühlmedium kann hier zum Beispiel in den Hohlraum gepumpt werden. Die beiden Kühldosen bestehen aus einer Keramik und sind elektrisch nicht oder nahezu nicht leitend. Erfindungsgemäß ist bei beiden Kühldosen zumindest ein Oberflächenbereich der Kühldose 1 durch die Funktionen elektrische und/oder thermische Leitfähigkeit definiert. Der Oberflächenbereich der Kühldosen 1, der durch die Funktionen elektrische und/oder thermische Leitfähigkeit definiert ist, ist eine mit dem Werkstoff der Kühldosen 1 versinterte Metallisierungsschicht. In der hier gezeigten Ausführungsform ist dieser Oberflächenbereich eine Platine 5. Diese Oberflächenbereiche können auf allen Seiten und auch im Hohlraum der Kühldosen 1 angeordnet sein.

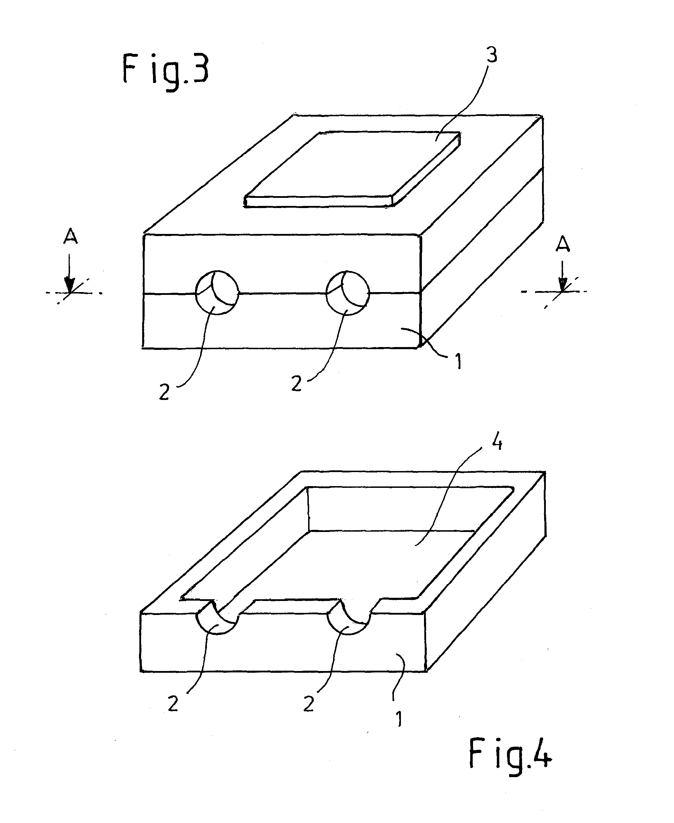

Figur 3 zeigt eine Kühldose 1, ähnlich Figur 1, die aus zwei Teilstücken besteht. Figur 4 zeigt einen Schnitt entlang der Linie A-A von Figur 3. Die beiden Teilstücke sind identisch ausgebildet und umschließen einen Hohlraum 4, der zwischen den beiden Teilstücken angeordnet ist. Dieser Hohlraum 4 steht über zwei Öffnungen 2 mit der Außenwelt in Verbindung. Über die beiden Öffnungen kann ein Kühlmedium in den Hohlraum 4 geleitet werden. Erfindungsgemäß ist auf der Oberseite der Kühldose 1 eine mit dem Werkstoff der Kühldose 1 versinterte Metallisierungsschicht 3 aufgebracht.

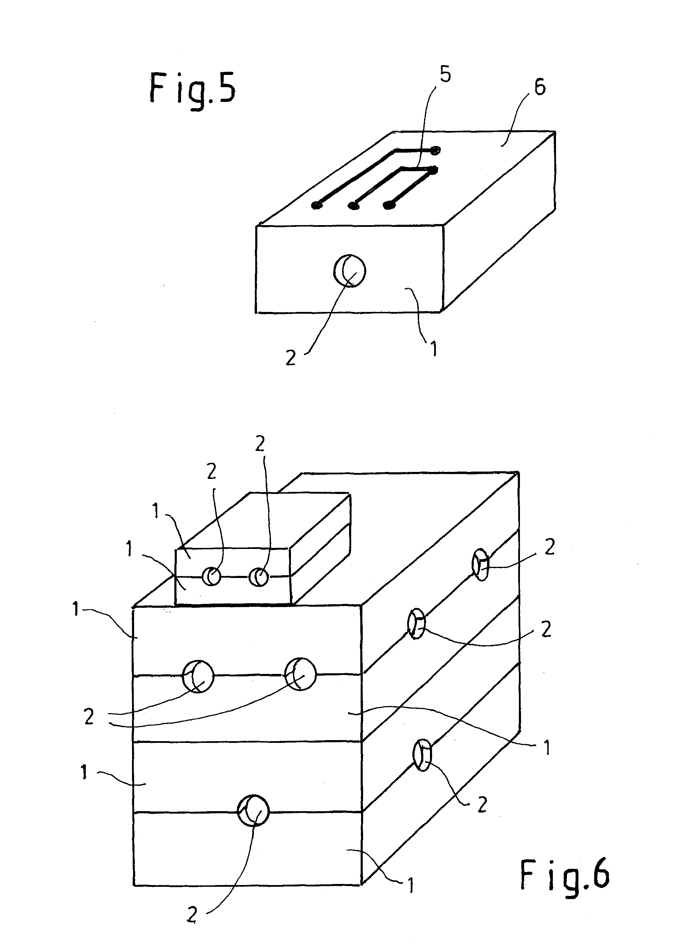

Figur 5 zeigt, wie die linke Kühldose aus Figur 2, eine einteilige Kühldose 1 mit einer Öffnung 2 für einen Hohlraum, hier nicht gezeigt. Auf der Oberfläche 6 der Kühldose 1 ist eine als Platine ausgebildete Metallisierungsschicht 5 aufgebracht. Auch hier besteht die Kühldose 1 aus einer Keramik als Werkstoff der Kühldose. Die Metallisierungsschicht 5 ist auch hier mit dem Werkstoff der Kühldose 1 versintert.
Figur 6 zeigt insgesamt drei Kühldosen 1, die zu einer Art dreidimensionalem Array miteinander verbunden sind. Jede der Kühldosen 1 weist Öffnungen 2 zur Zuführung des Kühlmittels auf. Nicht gezeigt ist, dass Oberflächenbereiche der Kühldosen 1 durch die Funktionen elektrische und/oder thermische Leitfähigkeit definiert sind, d.h. mit dem Werkstoff der Kühldosen 1 versinterte Metallisierungsschichten aufweisen.

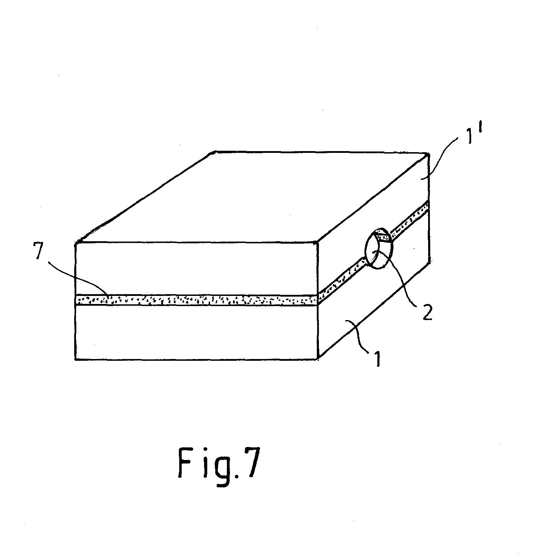

Figur 7 zeigt eine Kühldose 1, die aus zwei identischen Teilstücken 1' besteht. Miteinander verbunden sind diese Teilstücke 1' durch ein Verbindungsmaterial 7, hier ein Kleber. Auch hier sind die versinterten Metallisierungsschichten nicht gezeigt.

## Patentansprüche

1. Kühldose (1) für elektrische oder elektronische Bauelemente oder Schaltungen aus einem Werkstoff, wobei die Kühldose (1) elektrisch nicht oder nahezu nicht leitend ist, einstückig oder mehrstückig aufgebaut ist und über ein durch den Werkstoff umhüllten Hohlraum (4) verfügt und dieser Hohlraum (4) geschlossen oder mit mindestens einer Öffnung (2) versehen ist, **dadurch gekennzeichnet, dass** zumindest ein Oberflächenbereich der Kühldose (1) durch die Funktionen elektrische und/oder thermische Leitfähigkeit definiert ist und der Oberflächenbereich der Kühldose (1), der durch die Funktionen elektrische und/oder thermische Leitfähigkeit definiert ist, eine mit dem Werkstoff der Kühldose (1) versinterte Metallisierungsschicht (3) ist.

2. Kühldose nach Anspruch 1, **dadurch gekennzeichnet, dass** der Oberflächenbereich eine Platine (5) ist.

3. Kühldose nach Anspruch 1 oder 2, **dadurch gekennzeichnet, dass** die Metallisierungsschichten (3) größer 5 µm sind und über DCB Verfahren (Direct Copper Bonding) oder AMB Verfahren (Active Metall Brasing) aufgebracht sind.

4. Kühldose nach einem der Ansprüche 1 bis 3, **dadurch gekennzeichnet, dass** die Kühldose (1) teilweise mit metallischen Bereichen versehen ist.

5. Kühldose nach einem der Ansprüche 1 bis 4, **dadurch gekennzeichnet, dass** auf der Kühldose (1) Stoffe aufgebracht sind, welche Bondprozesse ermöglichen.

6. Kühldose nach einem der Ansprüche 1 bis 5, **dadurch gekennzeichnet, dass** mit der Kühldose (1) Metalle oder Metallschichten (3) innig oder durch mechanischen Formschluss vollflächig oder teilflächig verbundenen sind und eine gleiche oder unterschiedliche Wärmeleitfähigkeit wie die Kühldose besitzen.

7. Kühldose nach einem der Ansprüche 1 bis 6, **dadurch gekennzeichnet, dass** die Funktion der Metalle die elektrische Leitfähigkeit und/oder die thermische Leitfähigkeit und/oder eine Farbveränderung der Oberfläche und/oder eine thermische Spreizung und/oder ein Haftvermittler zu dritten Materialien, wie beispielsweise Loten, Klebern, sowie beliebige Kombinationen der Funktionen gleicher oder verschiedener Metallbereiche ist.

8. Kühldose nach einem der Ansprüche 1 bis 7, **dadurch gekennzeichnet, dass** die Metallisierungsschichten (3) auf der äußeren oder inneren Oberfläche der Kühldose (1) durch Versintern aufgebracht sind.

9. Kühldose nach einem der Ansprüche 1 bis 8, **dadurch gekennzeichnet, dass** die Metallisierungsschichten (3) aus Wolfram bestehen und bevorzugt chemisch vernickelt und/oder vergoldet sind.

10. Kühldose nach einem der Ansprüche 1 bis 9, **dadurch gekennzeichnet, dass** die Kühldose (1) mit elektrischen Leiterbahnen versehen ist, über die elektrische Spannungen bis in den kV Bereich hinein transportierbar sind, ohne dass ein elektrischer Spannungsabfluss über den Werkstoff der Kühldose (1) erfolgt.

11. Kühldose nach einem der Ansprüche 1 bis 10, **dadurch gekennzeichnet, dass** vollflächige oder teilflächige Oberflächenbereiche der Kühldose (1) mit hochstromtragfähigen Leiterbahnen und hochstromtragfähigen genormten oder ungenormten Leiteranschlüssen versehen sind.

12. Kühldose nach einem der Ansprüche 1 bis 11, **dadurch gekennzeichnet, dass** auf die Kühldose (1) mindestens eine dünne Schichte < 1.000 µm gleichen oder unterschiedlichen Materials durch Sputter- oder Lithografieverfahren oder Kombinationen derselben vollflächig oder teilflächig aufgebracht ist.
